# EUROPÄISCHE PATENTSCHRIFT

(11) **EP 1 119 004 B1**
(45) Veröffentlichungstag und Bekanntmachung des Hinweises auf die Patenterteilung: **15.10.2008**
(21) Anmeldenummer: 00128666.5
(22) Anmeldetag: 28.12.2000
(51) Int. Cl.: G11C 11/406, G11C 11/22

(54) **Halbleiter-Speicheranordnung mit Auffrischungslogikschaltung sowie Verfahren zum Auffrischen des Speicherinhaltes einer Halbleiter-Speicheranordnung**
Semiconductor memory with refresh controller and method for refreshing the content of a semiconductor memory
Dispositif de mémoire à semiconducteurs avec un contrôleur de rafraîchissement et méthode de rafraîchissement du contenu d'un dispositif de mémoire à semiconducteurs

(30) Priorität: 20.01.2000 DE 10002374
(43) Veröffentlichungstag der Anmeldung: 25.07.2001
(73) Patentinhaber: Infineon Technologies AG, 81669 München (DE)
(72) Erfinder: Boehm, Thomas, 85604 Zorneding (DE); Braun, Georg, 80339 München (DE); Hönigschmid, Heinz, East Fishkill, NY 12524 (US); Röhr, Thomas, Dr., 85609 Aschheim (DE)
(74) Vertreter: Epping - Hermann - Fischer

(56) Entgegenhaltungen:
- FR-A- 2 775 382
- US-A- 5 652 729
- US-A- 5 969 981

## Beschreibung

Die vorliegende Erfindung betrifft eine Halbleiter-Speicheranordnung mit einem Speicherzellenfeld aus einer Vielzahl von Speicherzellen, die über Wortleitungen und Bitleitungen ansteuerbar sind, und mit einer Auffrischungslogikschaltung zum Auffrischen des Speicherinhaltes der Speicherzellen des Speicherzellenfeldes, wobei die Speicherzellen einen Kondensator und einen Transistor umfassen, die zwischen einen Anschluß für ein Potential und einen Knotenpunkt in Reihe geschaltet sind.

Eine derartige Speicheranordnung ist beispielsweise in Form einer ferroelektrischen Speicheranordnung bekannt aus der Veröffentlichung von Hiroki Koike et al.: A 60 ns 1 Mb Nonvolatile Ferroelectric Memory with Non-Driven Cell Plate Line Write/Read Scheme, 1996, IEEE International Solid State Circuits Conference, Seiten 368 und 369, 1996. Um ferroelektrische Speicheranordnungen mit hoher Dichte bereitstellen zu können, ist es erforderlich, für die Speicherkondensatoren eine gemeinsame Elektrode vorzusehen und diese auf einem konstanten Potential zu halten. Dieses konstante Potential wird dabei insbesondere durch das arithmetische Mittel aus den beiden Spannungen gebildet, die auf einer Bitleitung zum Schreiben von Informationen in eine Speicherzelle verwendet werden. Dieses Konzept ist als "VDD/2-Konzept" allgemein bekannt. Problematisch bei Speicherzellen aus einem Transistor und einem ferroelektrischen Kondensator (1T1C-Zellen) und bei Speicherzellen aus zwei Transitoren und zwei ferroelektrischen Kondensatoren (2T2C-Zellen) ist, daß bei Anwendung des VDD/2-Konzeptes Leckströme im Substrat, sogenannte Unterschwellstöme, und Leckströme durch den gesperrten pn-Übergang unvermeidlich sind. Weiterhin treten Leckströme durch das Kondensatordielektrikum auf, deren Absolutwerte meistens vernachlässigbar gering sind und die einen bereits beträchtlichen Spannungsabfall am Speicherkondensator voraussetzen. Die Größe der verschiedenen Leckströme unterliegt starken Schwankungen infolge der Fertigungstoleranzen und der starken Temperaturabhängigkeit der Leckströme.

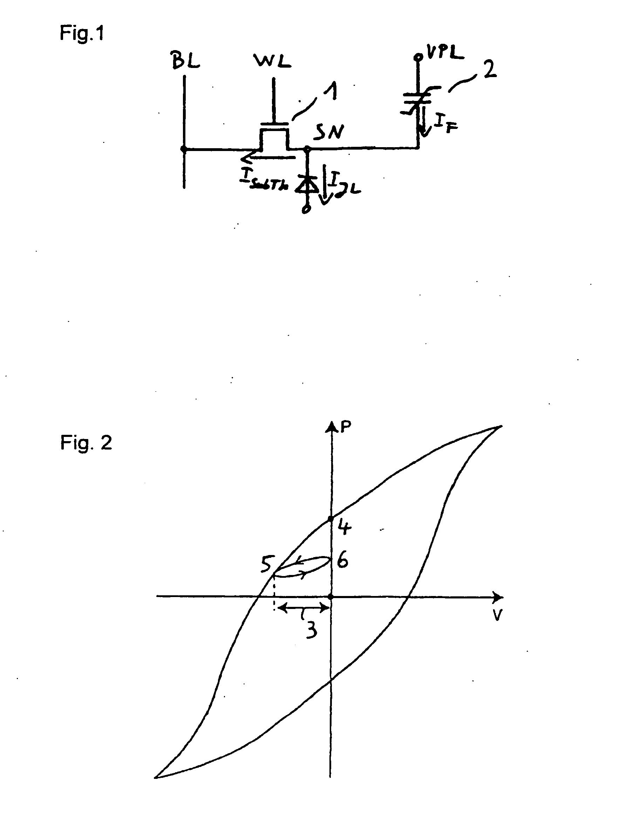

Fig.1 zeigt eine Speicherzelle mit einer Bitleitung BL, einer Wortleitung WL, einem Auswahltransistor 1, einem Speicherkondensator 2, dessen eine Elektrode auf einem konstanten Potential VPL mit anderen entsprechenden Elektroden der Speicherkondensatoren von weiteren Speicherzellen gehalten ist (nicht gezeigt), und einem Speicherknoten SN. Der Unterschwellstrom I_{SubTh} zwischen Source und Drain des Auswahltransistors 1, der Leckstrom I_{JL} des gesperrten pn-Überganges über eine entsprechende Diode zum Substrat und der Leckstrom I_{F} durch das Kondensatordielektrikum sind jeweils durch einen entsprechenden Pfeil veranschaulicht. Der Unterschwellstrom I_{subTh} kann kompensiert werden, indem die Bitleitung BL im Bereitschaftsmodus auf dem gleichen Potential wie die gemeinsame Elektrode, also auf dem Potential VPL gehalten wird.

Problematischer im Vergleich zu dem Unterschwellstrom ist der Leckstrom I_{JL} über den gesperrten pn-Übergang. Zur Überwindung der mit diesem Leckstrom I_{JL} verbundenen Probleme gibt es bisher zwei Lösungsansätze. Beide beruhen darauf, daß die Ladung, die durch den gesperrten pn-Übergang abfließt, entweder ständig oder zyklisch durch den Auswahltransistor 1 der Speicherzelle nachgeliefert wird (vgl. hierzu auch die oben angegebene Literaturstelle von Hiroki Koike). Ein zyklisches Einschalten des Auswahltransistors 1 weist jedoch den Nachteil auf, daß durch den Leckstrom I_{JL} zwischen den Auffrischungszyklen Störimpulse am Speicherkondensator 2 auftreten, die sich allenfalls in ihrer Amplitude begrenzen lassen. Ein derartiges Vorgehen ist jedoch schwierig, da der Leckstrom I_{JL} eines gesperrten pn-Überganges nicht nur starken Schwankungen unterliegt, sondern auch mit der Temperatur beträchtlich ansteigt. Zu den Störimpulsen und deren Auswirkungen am Speicherkondensator 2 sei dabei auf Fig. 2 verwiesen, in welcher die Hysteresekurve eines ferroelektrischen Speicherkondensators aufgetragen ist. Diese Hysteresekurve zeigt, daß es beispielsweise bei einer am Kondensator liegenden Spannung V = 0 zwei Polarisationszustände P gibt, welche die gespeicherte Information repräsentieren. Wandert beispielsweise infolge eines durch den Leckstrom I_{JL} verursachten Störimpulses 3 die Polarisation P von einem Punkt 4 zu einem Punkt 5 und liegt nach Abklingen des Störimpulses 3 wieder die Spannung V = 0 am Speicherkondensator 2 an, so geht die Polarisation nicht zu dem Punkt 4 zurück, sondern wandert vielmehr zu einem Punkt 6, der unterhalb des Punktes 4 gelegen ist. Mehrere Störimpulse 3 können auf diese Weise bewirken, daß schließlich die im Kondensator 2 gespeicherte Information bzw. Polarisation verloren geht.

Ein ständiges Einschalten des Auswahltransistors zum Schutz des Speicherinhaltes im Unterschied zum zyklischen Einschalten ist andererseits nur möglich, solange nicht auf die Speicheranordnung zugegriffen wird. Erfolgt ein Zugriff, so darf nur die betreffende Wortleitung des Speicherzellenfeldes aktiv sein, während alle anderen Wortleitungen abgeschaltet sein müssen. Dieses Abschalten ist an sich unproblematisch. Nach dem Speicherzugriff müssen aber zur Kompensation der Leckströme bzw. zum Auffrischen des Speicherinhaltes wieder alle Wortleitungen eingeschaltet werden, was durch die hohe kapazitive Last aller Wortleitungen insgesamt einen großen Anstieg des Leistungsbedarfs der Speicheranordnung bewirkt.

Um diesen Leistungsbedarf zu begrenzen, ist bei der ferroelektrischen Speicheranordnung gemäß der Druckschrift DE 198 30 568 A1 vorgesehen, daß die Bitleitung in k Segmente unterteilt ist, die lokale Bitleitungen bilden, und die lokalen Bitleitungen über k Schalter mit einer globalen Bitleitung verbunden sind.

Weiterhin sind entsprechende Auffrischungslogikschaltungen bei anderen Halbleiter-Speicheranordnungen, wie z.B. DRAMs oder EPROMs allgemein bekannt, die ebenfalls verhindern, daß gespeicherte Information verloren geht. Bei DRAMS werden wegen der auftretenden Leckströme die Inhalte aller Speicherzellen in regelmäßigen zeitlichen Abständen ausgelesen und wieder zurückgeschrieben. Bei EPROMs kann ein Informationsverlust infolge des unzulässigen Verschiebens der Speichertransistor-Einsatzspannung das ständige Auffrischen der Speicherinhalte erforderlich machen.

In der US 5 278 796 ist eine Refresh-Steuerschaltung für ein DRAM beschrieben, die einen temperaturabhängigen Wiederauffrischungszyklus liefert. Ein Temperatursensor erzeugt ein temperaturabhängiges Signal, welches in einem Komparator mit einer vorgegebenen Referenzspannung verglichen wird. Die Zeitdauer bis zum nächsten Einschalten des Wiederauffrischungszykluses wird dadurch temperaturabhängig gesteuert.

In der US 5 539 703 ist ein DRAM mit einer Refresh-Ansteuerschaltung gezeigt. Um die Wiederauffrischungszyklen an Schwankungen des Herstellungsprozesses anzupassen, ist ein Kondensator innerhalb des die Wiederauffrischung steuernden Oszillators vergleichbar einen oder mehreren Kondensatoren der Speicherzellen ausgeführt.

Die französische Patentanmeldung FR 2 775 382 zeigt eine integrierte Halbleiterschaltung mit einem Speicherzellenfeld, das normale Speicherzellen enthält, und einer Refresh-Steuerschaltung. Die Refresh-Steuerschaltung enthält zwei zu den normalen Speicherzellen entsprechende Speicherzellen, die eine "0" bzw. eine "1" speichern. Der Ladungsinhalt der Speicherzellen der Refresh-Steuerschaltung wird mit einer Referenzspannung verglichen. Abhängig davon wird der Wiederauffrischungsvorgang für das Speicherzellenfeld gesteuert.

In der US 5 652 729 ist ein anderer Halbleiterspeicher gezeigt, bei dem Entladevorgänge in einer Referenzspeicherzelle zur Steuerung der Wiederauffrischung der Speicherzellen des Hauptspeicherfeldes dienen. Über einen Vergleicher wird eine an einem Kondensator anliegende Spannung der Referenzspeicherzelle mit einer Referenzspannung verglichen. Es wird überlegt, ungefähr 1000 Referenzspeicherzellen zueinander parallel zu schalten, um beispielsweise den Effekt von Rauschen in der Vergleichsschaltung auszugleichen.

Aufgabe der vorliegenden Erfindung ist es, bei einer Halbleiter-Speicheranordnung die Durchführung der Auffrischungszyklen bezüglich des erforderlichen Energiebedarfes möglichst günstig zu gestalten.

Diese Aufgabe wird durch eine Halbleiter-Speicheranordnung nach Anspruch 1 und ein Verfahren nach Anspruch 5 gelöst. Bevorzugte Ausführungsformen sind in den abhängigen Ansprüchen angegeben.

Bei einer Halbleiter-Speicheranordnung und einem Verfahren zum Auffrischen des Speicherinhaltes einer Halbleiter-Speicheranordnung wird mit Hilfe einer Vergleichsschaltung eine charakteristische Größe zumindest einer Referenz-Speicherzelle mit einem Referenzwert verglichen und bei Bedarf eine Auffrischungslogikschaltung aktiviert. Der Auffrischungsvorgang im Speicherzellenfeld der Speicheranordnung wird also nicht jeweils in starren, durch eine interne Timerschaltung vorgegebenen, Zeitabständen gestartet, sondern nur dann ausgeführt, wenn er tatsächlich notwendig ist. Der Auffrischungszyklus wird dabei in Abhängigkeit vom elektrischen Zustand der Speicherzellen getriggert. Es wird insbesondere keine Energie für nicht notwendige Auffrischungszyklen verschwendet, was bei dem für mobile Applikationen geforderten, besonders geringen Energieverbrauch sehr wichtig ist.

Die Speicheranordnung weist spezielle Referenz-Speicherzellen auf, deren charakteristische Größen von der Vergleichsschaltung ausgewertet wird, um den Auffrischungsvorgang bedarfsgerecht steuern zu können. Diese gesonderten Referenz-Speicherzellen sind in einfacher Weise mit der Vergleichsschaltung zu verschalten. Alternativ ist es auch möglich, daß beispielsweise sich beim Speicherfunktionstest als besonders schlecht erweisende bzw. durch Leckströme besonders betroffene Speicherzellen des Speicherzellenfeldes als Referenzmeßzellen definiert und im Betrieb des Halbleiterspeichers verwendet werden. Bei der Herstellung und Auswahl der Referenz-Speicherzellen ist zu beachten, daß diese prozeßtechnisch und von den sie beeinflussenden Umgebungsbedingungen, insbesondere der Betriebstemperatur, möglichst den aufzufrischenden Speicherzellen entsprechen sollten.

Nachfolgend ist anhand schematischer Darstellungen ein Ausführungsbeispiel der erfindungsgemäßen Halbleiter-Speicheranordnung am Beispiel einer ferroelektrischen Speicheranordnung beschrieben. Es zeigen
- Fig. 1: ein Schaltbild einer bestehenden ferroelektrischen Speicherzelle mit den auftretenden Leckströmen,
- Fig. 2: eine Hysteresekurve für einen ferroelektrischen Speicherkondensator, und
- Fig. 3: ein vereinfachtes Schaltbild einer ferroelektrischen Speicheranordnung.

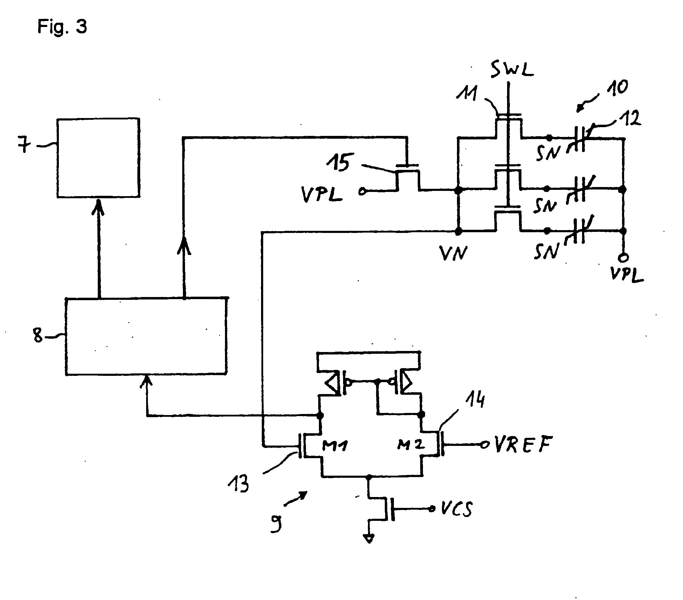

Eine ferroelektrische Speicheranordnung weist ein Speicherzellenfeld 7, eine Auffrischungslogikschaltung 8, eine Vergleichsschaltung 9 sowie ein Referenz-Speicherzellenfeld 10 auf (Fig. 3). Im nicht näher dargestellten allgemein bekannten Speicherzellenfeld 7 sind die gemeinsamen Elektroden der ferroelektrischen Speicherkondensatoren von Speicherzellen gemäß Fig. 1 auf einem Potential VPL gehalten, das typischerweise 1,25 V beträgt, wobei VPL = VDD/2 gilt. Durch das Anlegen von Spannungen, die kleiner oder größer als VPL sind, an die andere Elektrode des Speicherkondensators 2 über die Bitleitung BL und das Einschalten des Auswahltransistors 1 über die Wortleitung WL erfolgt die Erzeugung eines gewünschten Polarisationszustandes im Dielektrikum des Speicherkondensators 2 und damit die Speicherung der Information in der ferroelektrischen Speicherzelle (Fig. 1). Als Auffrischungslogikschaltung 8 können beispielsweise aus der DRAM-Technik bekannte Schaltungen oder die in der oben angegebenen Literaturstelle von Hiroki Koike beschriebenen Anordnung verwendet werden. Das Referenz-Speicherzellenfeld 10 umfasst beispielsweise drei parallel geschaltete ferroelektrische Speicherzellen, die jeweils einen Referenz-Auswahltransistor 11 und einen ferroelektrischen Referenz-Speicherkondensator 12 aufweisen. Die drei Speicherzellen werden von einer Steuerwortleitung SWL der Auffrischungslogikschaltung 8 angesteuert. Alternativ besteht auch die Möglichkeit, mehrere, z. B. drei Steuerwortleitungen SWL zum Ansteuern der drei Speicherzellen einzusetzen.

Eine Elektrode der Referenz-Speicherkondensatoren 12 wird auf dem konstanten Potential VPL gehalten, das gleich dem gemeinsamen Potential der Speicherkondensatoren 2 des Speicherzellenfeldes 7 ist (Fig. 1). Die andere Elektrode des Referenz-Speicherkondensators 12 stellt jeweils den Speicherknoten SN der Referenz-Speicherzelle dar und ist beispielsweise mit dem Drain des jeweiligen Referenz-Auswahltransistors 11 verbunden. Die Sources der Referenz-Auswahltransistoren 11 liegen gemeinsam an einem Vergleichs-Speicherknoten VN, der mit dem Gate eines Eingangstransistors 13 eines als Vergleichsschaltung 9 dienenden an sich bekannten Differenzverstärkers verbunden ist. Dabei ist zur Vermeidung von Meßfehlern zu beachten, daß die Eingangskapazität des Differenzverstärkers 9 klein gegenüber der Kapazität der Referenz-Meßzellen 10 gewählt ist. Der Differenzverstärker 9 vergleicht jeweils das Potential an einem der Speicherknoten SN bzw. am Vergleichs-Speicherknoten VN mit einer am Gate des zweiten Eingangstransistors 14 des Differenzverstärkers 9 anliegenden Referenzspannung VREF. Für diese gilt beispielsweise VREF = VPL - 0,1 V. Der Spannungswert wird dabei in Abhängigkeit von der gewünschten Datensicherheit des Speicherinhaltes des Speicherzellenfeldes 7 einerseits und dem gewünschten geringen Energieverbrauch infolge des Auffrischungsvorganges andererseits gewählt. Alternativ könnte auch vorgesehen sein, VREF = VPL zu setzen und die Eingangstransistoren 13, 14 des Differenzverstärkers 9 asymmetrisch zu dimensionieren. Auf diese Weise wird eine Offsetspannung im Differenzverstärker 9 erzeugt, die die gleiche Funktion erfüllt wie die oben angegebene Differenzspannung von 100 mV. Die Vergleichsschaltung 9 kann dabei so gestaltet sein, daß nur eine Unter- oder Überschreitung eines geeigneten Referenzwertes ausgewertet wird, oder daß beide Abweichungen registriert werden und einen Auffrischungsvorgang auslösen.

Der Ausgang des Differenzverstärkers 9 ist mit der Auffrischungslogikschaltung 8 verbunden, die den Auffrischungsvorgang für das Speicherzellenfeld 7 des ferroelektrischen Halbleiterspeichers bei Bedarf einleitet. Zusätzlich steuert die Auffrischungslogikschaltung 8 eine Leckstromkompensationsschaltung mit einem Leckstromkompensationstransistor 15 an. Die Schaltung 8 schaltet den Transistor 15 kurzzeitig ein bzw. aktiviert dadurch eine Schreibschaltung für die Referenz-Speicherzellen 10, so daß zeitgleich mit dem Auffrischen des Inhaltes des Speicherzellenfeldes 7 die gewünschte Spannung VPL an den drei Speicherknoten SN der Referenz-Speicherkondensatoren 12 wieder hergestellt wird. Dazu sind das Gate des Leckstromkompensationstransistors 15 sowie die Steuerwortleitung SWL der Referenz-Speicherzellen 10 mit entsprechenden Ausgängen der Auffrischungslogikschaltung 8 verbunden.

Die Funktion der ferroelektrischen Speicheranordnung gemäß Fig. 3 ist wie folgt. Zu Beginn werden über die Steuerwortleitung SWL die drei Referenz-Auswahltransistoren 11 und der Leckstromkompensationstransistor 15 eingeschaltet. Dadurch werden die Potentiale in den drei Speicherknoten SN der drei Referenz-Speicherkondensatoren 12 auf den Wert VPL eingestellt, und damit die über den ferroelektrischen Kondensator abfallende Spannung auf 0 V reduziert. Anschließend wird der Leckstromkompensationstransistor 15 wieder ausgeschaltet. Die oben beschriebenen Leckströme verursachen während des Betriebes der ferroelektrischen Speicheranordnung gegebenenfalls voneinander abweichenden Veränderungen der Potentiale der drei Speicherknoten SN in den Referenz-Speicherzellen 10 und entsprechende, unerwünschte Potentialänderungen in den Speicherzellen des Speicherzellenfeldes 7. Die Potentiale der drei Speicherknoten SN der Referenz-Speicherzellen 10 werden nacheinander durch den jeweiligen Referenz-Auswahltransistor 11 und den Differenzverstärker 9 mit dem Referenzwert VREF verglichen. Die Referenz-Auswahltransistoren 11 können dabei permanent angeschaltet sein oder auch periodisch vom Differenzverstärker 9 zur Vergleichsmessung eingeschaltet werden.

Sobald die Abweichung an einem dieser drei Speicherknoten größer ist als zulässig, startet die Auffrischungslogikschaltung 8 einen Auffrischungsvorgang. Dabei wird in an sich bekannter Weise der Inhalt der Speicherzellen des Speicherzellenfeldes 7 aufgefrischt. Zudem werden die durch die Leckströme in den Referenz-Speicherzellen 10 verursachten Ladungsverluste wieder ausgeglichen und die Potentiale der drei Referenz-Speicherknoten SN wieder auf den Ausgangswert VPL gestellt. Der Differenzverstärker 9 setzt den oben beschriebenen Spannungsvergleich wieder fort.

Die Erfindung kann bei allen Halbleiterspeichertypen, bei denen eine Auffrischung des Speicherinhalts erforderlich ist, insbesondere bei DRAMs, EPROMs und Flash-Speichern eingesetzt werden.

## Patentansprüche

1. Halbleiter-Speicheranordnung, umfassend:
- ein Speicherzellenfeld mit einer Vielzahl von Speicherzellen, die über Wortleitungen und Bitleitungen ansteuerbar sind, und eine Auffrischungslogikschaltung (8) zum Auffrischen des Speicherinhaltes der Speicherzellen des Speicherzellenfeldes (7);
- wobei die Speicherzellen jeweils einen Kondensator (2) und einen Transistor (1) umfassen, die zwischen einen Anschluß für ein Potential (VPL) und einen Knotenpunkt in Reihe geschaltet sind;
- eine Steuerungsschaltung, die eine Vergleichsschaltung (9), mehrere Speicherzellen (10) und die Auffrischungslogikschaltung (8) enthält;
- wobei die mehreren Speicherzellen (10) der Steuerschaltung jeweils einen Kondensator (12) und einen Transistor (11) enthalten, die in Reihe zwischen den Anschluß für das Potential (VPL) und einen weiteren Knoten (VN) geschaltet sind;
- wobei die Vergleichschaltung (9) ausgangsseitig die Auffrischungslogikschaltung (8) zur Veranlassung der Wiederauffrischung der Speicherzellen des Speicherzellenfeldes (7) steuert und eingangsseitig mit dem weiteren Knoten (VN) der Steuerschaltung und einem Anschluß für eine Referenzspannung (VREF) verbunden ist;
- wobei der weitere Knoten (VN) der Steuerschaltung über einen weiteren Transistor (15) zur Leckstromkompensation mit dem Anschluß für das Potential (VPL) verbunden ist;
- wobei die Steuerschaltung ausgebildet ist, daß zuerst der weitere Transistor (15) und die Transistoren (11) der mehreren Speicherzellen (10) der Steuerschaltung gemeinsam leitend geschaltet werden und anschließend der weitere Transistor (15) abgeschaltet wird und die Transistoren (11) der mehreren Speicherzellen (10) der Steuerschaltung leitend geschaltet werden.

2. Halbleiter-Speicheranordnung nach Anspruch 1,
**dadurch gekennzeichnet, daß**
die Auffrischungslogikschaltung (8) sowohl den Speicherinhalt der Speicherzellen des Speicherzellenfeldes (7) als auch der mehreren Speicherzellen (10) der Steuerschaltung auffrischt.

3. Halbleiter-Speicheranordnung nach Anspruch 1 oder 2,
**dadurch gekennzeichnet, daß**
die Speicheranordnungfür die Speicherzellen des Speicherfeldes und für die mehreren Speicherzellen der Steuerschaltung jeweils ferroelektrische Speicherzellen umfaßt.

4. Halbleiter-Speicheranordnung nach einem der Ansprüche 1 bis 3,
**dadurch gekennzeichnet, daß**
die Eingangskapazität der Vergleichsschaltung (9) im Vergleich zur Kapazität der mehreren Speicherzellen (10) der Steuerschaltung vernachlässigbar klein ist.

5. Verfahren zum Auffrischen des Speicherinhaltes von Speicherzellen (2, 1) eines Speicherzellenfeldes (7) einer Halbleiter-Speicheranordnung nach einem der vorhergehenden Ansprüche 1 bis 4, umfassend die folgenden Schritte:
- Vergleichen eines Ausgangssignals mehrerer weiterer Speicherzellen (10) mit einem Referenzpotential (VREF) und Starten eines Auffrischungszyklusses bei jedem Vorliegen einer unzulässig großen Abweichung zwischen dem Ausgangssignal und dem Referenzwert (VREF);
- Verbinden einer Elektrode des Kondensators der weiteren Speicherzelle (10) mit einem festen Potential (VPL);
- wobei zuerst der weitere Transistor (15) und die Transistoren (11) der mehreren Speicherzellen (10) der Steuerschaltung gemeinsam leitend geschaltet werden und anschließend der weitere Transistor (15) abgeschaltet wird und die Transistoren (11) der mehreren Speicherzellen (10) der Steuerschaltung leitend geschaltet werden.

## Claims

1. A semiconductor memory configuration, comprising:
- a memory cell array having a plurality of memory cells which can be controlled by word lines and bit lines, and a refresh logic circuit (8) to refresh the memory content of the memory cells of the memory cell array (7);
- wherein the memory cells each comprise a capacitor (2) and a transistor (1) connected in series between a terminal for a potential (VPL) and a node;
- a control circuit containing a comparison circuit (9), several memory cells (10), and the refresh logic circuit (8)
- wherein the several memory cells (10) of the control circuit contain a capacitor (12) and a transistor (11) being connected in series between the terminal for the potential (VPL) and a further node (VN);
- wherein the comparison circuit (9) controls the refresh logic circuit (8) at its output side to cause the memory cells in the memory cell array (7) to be refreshed and is connected with the further node (VN) of the control circuit and a terminal for a reference voltage (VREF) at its input side;
- wherein the further node (VN) of the control circuit is connected via a further transistor (15) with the terminal for the potential (VPL) for leakage current compensation;
- wherein the control circuit is configured such that firstly the further transistor (15) and the transistors (11) of the several memory cells (10) of the control circuit are jointly switched conductive and afterwards the further transistor (15) is switched off and the transistors (11) of the several memory cells (10) of the control circuit are switched conductive.

2. The semiconductor memory configuration according to claim 1,
**characterized in that** the refresh logic circuit (8) refreshes both the memory content of the memory cells of the memory cell array (7) and the several memory cells (10) of the control circuit.

3. The semiconductor memory configuration according to claim 1 or 2,
**characterized in that** the memory configuration for the memory cells of the memory cell array and for the several memory cells of the control circuit each comprise ferroelectric memory cells.

4. The semiconductor memory configuration according to one of the claims 1 to 3,
**characterized in that** the input capacitance of the comparison circuit (9) is negligibly small compared to the capacitance of the several memory cells (10) of the control circuit.

5. A method of refreshing the memory content of memory cells (2, 1) of a memory cell array (7) of a semiconductor memory configuration according to one of the previous claims 1 to 4, comprising the following steps:
- comparing an output signal of several further memory cells (10) with a reference potential (VREF) and starting a refresh cycle each time there is an inadmissible large difference between the output signal and the reference value (VREF);
- connecting an electrode of the capacitor of the further memory cell (10) with a fixed potential (VPL);
- wherein firstly the further transistor (15) and the transistors (11) of the several memory cells (10) of the control circuit are jointly switched conductive and afterwards the further transistor (15) is switched off and the transistors (11) of the several memory cells (10) of the control circuit are switched conductive.

## Revendications

1. Dispositif de mémoire à semiconducteurs comprenant :
- un champ de cellules de mémoire ayant une pluralité de cellules de mémoire, qui peuvent être commandées par des lignes de mots et par des lignes de bits et un circuit ( 8 ) logique de rafraîchissement pour rafraîchir le contenu des cellules du champ ( 7 ) de cellules de mémoire ;
- dans lequel les cellules de mémoire comprennent respectivement un condensateur ( 2 ) et un transistor ( 1 ) qui est monté en série entre une borne pour un potentiel ( VLP ) et un point nodal ;
- un circuit de commande qui comporte un circuit ( 9 ) de comparaison, plusieurs cellules ( 10 ) de mémoire et le circuit ( 8 ) de rafraîchissement ;
- dans lequel les plusieurs cellules ( 10 ) de mémoire du circuit de commande comportent respectivement un condensateur ( 12 ) et un transistor ( 11 ) qui sont montés en série entre la borne pour le potentiel ( VLP ) et un autre noeud ( VN ) ;
- dans lequel le circuit ( 9 ) de comparaison commande, du côté de la sortie, le circuit ( 8 ) logique de rafraîchissement pour provoquer le rafraîchissement des cellules du champ ( 7 ) de cellules de mémoire et du côté de l'entrée est relié à l'autre noeud ( VN ) du circuit de commande et à une borne pour une tension ( VREF ) de référence ;
- dans lequel l'autre noeud ( VN ) du circuit de commande est relié par un autre transistor ( 15 ) de compensation du courant de fuite à la borne pour le potentiel ( VN ) ;
- dans lequel le circuit de commande est constitué de manière à ce que d'abord l'autre transistor ( 15 ) et les transistors ( 11 ) des plusieurs cellules ( 10 ) de mémoire du circuit de commande soient conjointement passants et qu'ensuite l'autre transistor ( 15 ) soit bloqué et les transistors ( 11 ) edest plusieurs cellules ( 10 ) de mémoire du circuit de commande soient passants.

2. Dispositif de mémoire à semiconducteurs selon la revendication 1,
**caractérisé en ce que**,
le circuit ( 8 ) logique de rafraîchissement rafraîchit tant le contenu des cellules du champ ( 7 ) de cellules de mémoire qu'également de plusieurs cellules ( 10 ) de mémoire du circuit de commande.

3. Dispositif de mémoire à semiconducteurs selon la revendication 1 ou 2,
**caractérisé en ce que**,
le dispositif de mémoire pour les cellules du champ de mémoire et pour les plusieurs cellules de mémoire du circuit de commande comprend respectivement des cellules de mémoire ferroélectriques.

4. Dispositif de mémoire à semiconducteurs selon les revendications 1 à 3,
**caractérisé en ce que**,
la capacité d'entrée du circuit ( 9 ) de comparaison est petite en étant négligeable par rapport à la capacité des plusieurs cellules ( 10 ) de mémoire du circuit de commande.

5. Procédé de rafraîchissement du contenu de mémoire de cellules ( 2, 1 ) d'un champ ( 7 ) de cellules de mémoire à dispositif de mémoire à semiconducteurs selon l'une des revendications précédentes 1 à 4 comprenant les stades suivants dans lesquels :
- on compare un signal de sortie de plusieurs autres cellules ( 10 ) de mémoire à un potentiel ( VREF ) de référence et on lance un cycle de rafraîchissement à chaque présence d'un écart inadmissiblement grand entre le signal de sortie et la valeur ( VREF ) de référence ;
- on relie une électrode du condensateur de l'autre cellule ( 10 ) de mémoire à un potentiel ( VPL ) ;
- dans lequel d'abord l'autre transistor ( 15 ) et les transistors ( 11 ) des plusieurs cellules ( 10 ) de mémoire du circuit de commande sont conjointement passants et ensuite le transistor ( 15 ) est bloqué et les transistors ( 11 ) des plusieurs cellules ( 10 ) de mémoire du circuit de commande sont passants.
